Europäisches Patentamt

European Patent Office

Office européen des brevets

(11) Veröffentlichungsnummer: **0 401 396 B1**

(19)

(12) **EUROPÄISCHE PATENTSCHRIFT**

(45) Veröffentlichungstag der Patentschrift: **11.05.94**

(21) Anmeldenummer: **89110162.8**

(22) Anmeldetag: **05.06.89**

(51) Int. Cl.⁵: **H03H 17/02**

(54) **Verfahren und Schaltungsanordnung zur Vermeidung von Überläufen bei einem adaptiven, rekursiven Wellendigitalfilter mit Festkommaarithmetik.**

(43) Veröffentlichungstag der Anmeldung:
**12.12.90 Patentblatt 90/50**

(45) Bekanntmachung des Hinweises auf die Patenterteilung:
**11.05.94 Patentblatt 94/19**

(84) Benannte Vertragsstaaten:
**DE FR GB IT NL**

(56) Entgegenhaltungen:
**US-A- 3 967 099**

(73) Patentinhaber: **SIEMENS AKTIENGESELL-SCHAFT**
**Wittelsbacherplatz 2**
**D-80333 München(DE)**

(72) Erfinder: **Gazsi, Lajos, Dr.Ing.**
**Faunastrasse 23**
**D-4000 Düsseldorf(DE)**
Erfinder: **Brückmann, Dieter, Dr.Ing.**
**Zur Lindung 9**
**D-4000 Düsseldorf(DE)**

## Beschreibung

Die Erfindung betrifft ein Verfahren zur Vermeidung von Überläufen bei einem adaptiven, rekursiven Wellendigitalfilter nach dem Oberbegriff des Patentanspruches 1 und eine Schaltungsanordnung zur Durchführung des Verfahrens.

Adaptive Filter sind in vielen Bereichen der zeitdiskreten Signalverarbeitung, insbesondere in den Bereichen Systemanalyse, Echokompensation bei Zweidraht-Vierdrahtübergängen, Leitungsentzerrung und Sprachverarbeitung, von großer Bedeutung. Das Charakteristikum solcher adaptiver Filter, im Vergleich zu konstanten Filtern, ist, daß die Filterparameter, welche die Übertragungseigenschaften bestimmen, gegenüber einem Gütefunktional optimal eingestellt werden. Ein derartiges Gütefunktional ist beispielsweise dadurch gegeben, daß der mittlere quadratische Fehler des Ausgangssignals des adaptiven Filters gegenüber einem Referenzsignal minimiert wird. Bei üblichen Verfahren werden dabei die partiellen Ableitungen (Gradient) des Gütefunktionals nach den zu adaptierenden Filterparametern gebildet. Für die meisten Gütekriterien ist dieses Verfahren zurückführbar auf die Bildung der partiellen Ableitungen des Ausgangssignals des adaptiven Filters nach den Filterparametern.

Aus der Europäischen Anmeldung EP-A-0 397 912 ist ein Verfahren und eine Anordnung zur Durchführung des Verfahrens bekannt, mit dem der Gradient des Ausgangssignals eines zeitdiskreten Netzwerkes, also beispielsweise eines Filters, bezüglich der Netzwerk- bzw. Filterparameter gewonnen werden kann. Das gesuchte Gradientensignal erscheint am Ausgang eines Gradientennetzwerkes, das durch interne Signale des Netzwerkes gespeist wird. Besonders einfach wird das Verfahren bzw. die Anordnung für lineare Netzwerke, da das Gradientennetzwerk im wesentlichen die gleiche Struktur wie das gegebenen Netzwerk aufweist, wodurch eine aufwendige Netzwerksynthese überflüssig wird. Weitere Vereinfachungen erhält man für Digitalfilter, die ausschließlich mit Zweitoradaptoren aufgebaut sind, und für Digitalfilter, bei denen die Netzwerkparameter Multipliziererkoeffizienten sind.

Beispielsweise aus der DE-PS 20 27 303 bekannte Wellendigitalfilter bestehen ausschließlich aus Verzögerungen und Adaptoren, die sich wiederum aus Addierern bzw. Subtrahierern sowie Multiplizierern zusammensetzen. Mit Hilfe der Multipliziererkoeffizienten können dabei unterschiedliche Übertragungsfunktionen eingestellt werden. Bei Verwendung der Wellendigitalfilter als adaptive Filter sind diese Koeffizienten variabel. Mit Hilfe verschiedener Verfahren, beispielsweise den Gradientenverfahren, lassen sich die Koeffizienten automatisch auf den gewünschten, optimalen Wert einstellen. Dazu werden die Ableitungen des Filterausgangssignales nach den einzelnen Koeffizienten benötigt. Diese Werte lassen sich mit Gradientenfiltern gemäß der Europäischen Anmeldung 89 10 90 86.2 bestimmen, wobei die Gradientenfilter ebenfalls als Wellendigitalfilter ausgeführt sind. Die Gradientenfilter bestehen somit auch aus Adaptoren und Verzögerungen. Das Eingangssignal des Gradientenfilters ergibt sich aus dem Eingangssignal des Multiplizierers zur Multiplikation mit jeweils einem der das Übertragungsverhalten bestimmenden Koeffizienten. Das Ausgangssignal des Gradientenfilters ist dann der entsprechende Gradient des Ausgangssignales des Übertragungsfilters bezüglich des Filterparameters bzw. des Koeffizienten.

Bei der Realisierung der Wellendigitalfilter sind dem Darstellungsbereich der digitalen Signale durch die Verarbeitungsbreite von Addierern, Subtrahierern und Multiplizierern Grenzen gesetzt. Bei Wellendigitalfiltern mit Festkommaarithmetik ist der darstellbare Signalbereich auf den Bereich $-1 \leq x \leq 1-2^{-n}$ beschränkt, wobei $n$ die Verarbeitungsbreite und $x$ das darstellbare Signal bedeutet. Überlauf entsteht, falls die Resultate der Additionen den verfügbaren Bereich überschreiten, so daß es zu einer Verfälschung der Ergebnisse kommt.

Für einen Adaptor eines Wellendigitalfilters gilt:

$$b_2 = (1-\mu) \cdot a_1 + \mu \cdot a_2, \quad (1)$$

wobei $a_1$ und $a_2$ die Eingangssignale sind und $\mu$ der gegebene Multipliziererkoeffizient ist, der Werte zwischen 0 und 1 annehmen kann. Da die Beträge der Eingangssignale $|a_1| \leq 1$ und $|a_2| \leq 1$ sind, gelten folgende Ungleichungen für den Betrag des Ausgangssignals $|b_2|$:

$$|b_2| \leq (1-\mu) \cdot |a_1| + \mu \cdot |a_2| \quad (2a)$$

$$|b_2| \leq 1-\mu + \mu \quad (2b)$$

$$|b_2| \leq 1. \quad (2c)$$

Damit ist gewährleistet, daß der Adaptor für das Ausgangssignal $b_2$ unter keinen Umständen Überläufe erzeugen kann. Dies gilt allerdings nicht für den entsprechenden Adaptor des Gradientenfilters, da

$$b_2' = a_1' + \mu \cdot a_2' \quad (3a)$$

$$|b_2'| \leq |a_1'| + \mu \cdot |a_2'| \quad (3b)$$

$$|b_2'| \leq 1 + \mu \quad (3c)$$

Wie aus den Gleichungen (3a) bis (3c) hervorgeht, kann das Ausgangssignal $b_2'$ des Teiladaptors des

Gradientenfilters also durchaus überlaufen. Selbst wenn das Eingangssignal $a_1'$ mit einem zwischen null und eins liegenden Faktor d skaliert wird, so tritt immer noch für das Ausgangssignal $b_2'$ ein Überlauf auf, falls $\mu$ im Bereich $1 - d < \mu \leq 1$ liegt.

Aufgabe der Erfindung ist es daher, ein Verfahren und eine Schaltungsanordnung zur Vermeidung von Überläufen bei einem Gradientenfilter eines adaptiven rekursiven Wellendigitalfilters anzugeben.

Diese Aufgabe wird bei einem gattungsgemäßen Verfahren durch die kennzeichnenden Merkmale des Patentanspruches 1 gelöst. Weiterbildungen des Erfindungsgedankens sind in Unteransprüchen gekennzeichnet.

Vorteil der Erfindung ist es, daß mit geringem Aufwand ein Überlaufen des Teiladaptors des Gradientenfilters sicher verhindert wird.

Die Erfindung wird nachfolgend anhand von den in den FIG der Zeichnung dargestellten Ausführungsbeispielen näher erläutert, wobei gleiche Elemente mit gleichen Bezugszeichen versehen sind. Es zeigt:

FIG 1 ein erstes Ausführungsbeispiel einer Schaltungsanordnung zur Durchführung des erfindungsgemäßen Verfahrens und

FIG 2 ein zweites Ausführungsbeispiel einer Schaltungsanordnung zur Durchführung des erfindungsgemäßen Verfahrens.

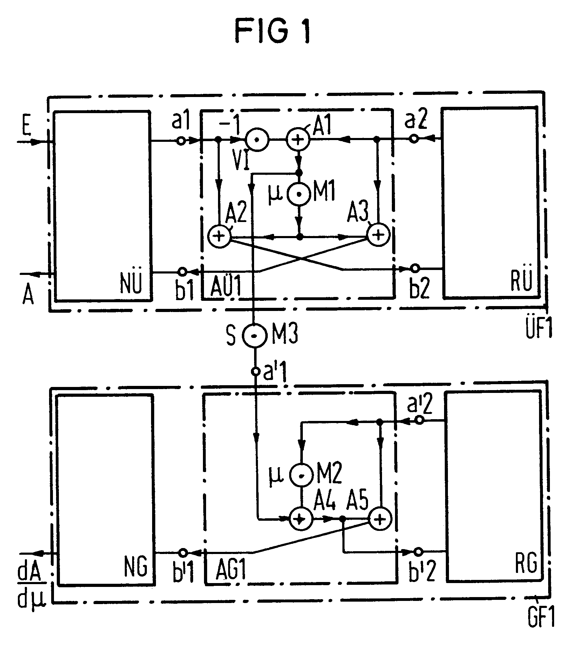

In dem Ausführungsbeispiel gemäß FIG 1 besteht ein gegebenes Übertragungsfilter ÜF1 aus einem nichtrekursiven Teilfilter NÜ, das mit einem Eingangssignal E beaufschlagt ist und ein Ausgangssignal A führt, aus einem rekursiven Teilfilter RÜ und aus einem Zweitoradaptor AÜ1, der von dem nichtrekursiven Teilfilter NÜ ein Signal $a_1$ erhält und an dieses ein Signal $b_1$ abgibt sowie von dem rekursiven Teilfilter RÜ ein Signal $a_2$ erhält und an dieses ein Signal $b_2$ abgibt. Ein zugehöriges Gradientenfilter GF1 umfaßt entsprechend ein nichtrekursives Teilfilter NG, das ein Ausgangssignal $dA/d\mu$ am Ausgang führt, ein rekursives Teilfilter RG und einen Adaptor AG1, der ein Signal $a_2'$ von dem nichtrekursiven Teilfilter RG erhält sowie ein Signal $b_1'$ an das nichtrekursive Teilnetzwerk NG und ein Signal $b_2'$ an das rekursive Teilnetzwerk RG abgibt. Darüber hinaus wird ein Signal $a_1'$ von dem Adaptor AÜ1 des Übertragungsfilters ÜF1 dem Adaptor AG1 des Gradientenfilters GF1 zugeführt. Dabei weisen die beiden nichtrekursiven Teilfilter NÜ und NG sowie die rekursiven Teilfilter RÜ und RG jeweils gleiches Übertragungsverhalten auf.

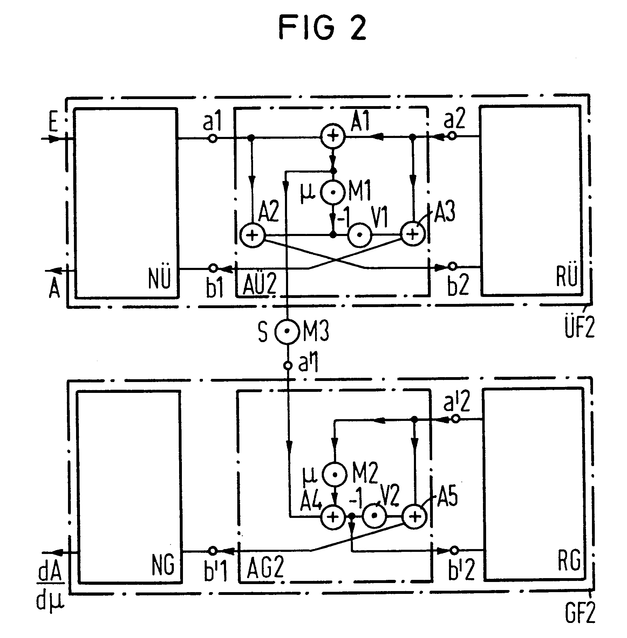

Das Ausführungsbeispiel gemäß FIG 2 ist prinzipiell im Aufbau dem Ausführungsbeispiel gemäß FIG 1 identisch. Beide Ausführungsbeispiele unterscheiden sich lediglich in der Ausgestaltung der verwendeten Adaptoren AÜ1 bzw. AÜ2 bei den Übertragungsfiltern ÜF1 bzw. ÜF2 und daraus resultierend auch in der Ausgestaltung der Adaptoren AG1 und AG2 der Gradientenfilter GF1 und GF2.

Gemäß FIG 1 sind bei dem Adaptor AÜ1 des Übertragungsfilters ÜF1 die einspeisenden Anschlüsse mit einem gemeinsamen Addierer A1 verbunden. In die Zuleitung, die das Signal $a_1$ führt, ist zudem ein Vorzeicheninverter V1 eingefügt. Zudem ist das Signal $a_1$ auf einen Addierer A2 und das Signal $a_2$ auf einen Addierer A3 geleitet. Der jeweils andere Eingang der beiden Addierer A2 und A3 ist unter Zwischenschaltung eines Multiplizierers M1 zur Multiplikation mit dem Koeffizienten $\mu$ mit dem Ausgang des Addierers A1 verbunden. Am Ausgang des Addierers A2 liegt das Signal $b_2$ und an dem Ausgang des Addierers A3 liegt das Signal $b_1$ an. Daraus abgeleitet ergibt sich für den Adaptor AG1 des Gradientenfilters GF1 folgende Struktur: Das Signal $a_1'$ ist direkt und das Signal $a_2'$ über einen Multiplizierer M2 zur Multiplikation mit dem Koeffizienten $\mu$ auf einen Addierer A4 geführt. Ein weiterer Addierer A5 ist mit dem Ausgangssignal des Addierers A4 und dem Signal $a_2'$ beaufschlagt. Das Signal $b_1'$ bzw. $b_2'$ liegt an dem Ausgang des Addierers A4 bzw. A5 an.

Gegenüber dem Adaptor AÜ1 des Ausführungsbeispiels gemäß FIG 1 ist der Adaptor AÜ2 des Ausführungsbeispiels gemäß FIG 2 lediglich dahingehend abgeändert, daß der Vorzeicheninverter V1 nicht in der Zuleitung des Addierers A1 liegt, sondern in die Leitung zwischen dem Multiplizierer M1 und dem Addierer A3 geschaltet ist. Dadurch ist aber auch der Adaptor AG2 aus FIG 2 gegenüber dem Adaptor AG1 nach FIG 1 abgewandelt, indem nämlich ein Vorzeicheninverter V2 zwischen den Ausgang des Addierers A4 und einem Eingang des Addierers A5 eingefügt ist.

Erfindungsgemäß wird in beiden Ausführungsbeispielen das an dem Eingang des Multiplizierers M1 abgegriffene und den Adaptor AG1 bzw. AG2 zugeführte Signal mit einem Skalierungsfaktor S multipliziert. Die Multiplikation mit dem Skalierungsfaktor S erfolgt durch einen Multiplizierer M3. Der Skalierungsfaktor S ist dabei gleich der Differenz aus 1 und dem Koeffizienten $\mu$.

Bei dem Ausführungsbeispiel gemäß FIG 1 ist der Adaptor AÜ1 gut skaliert für $\mu$ größer oder gleich null. Für diesen Fall gilt:

$$S = 1 - \mu \qquad (4a)$$

so daß

$$b_2' = (1-\mu) \cdot a_1' + \mu \cdot a_2' \qquad (4b)$$

wird. Ausgehend von Gleichung (4b) ist entsprechend der Argumentation in den Gleichungen (2a), (2b), (2c) sofort ersichtlich, daß der Skalierungsfaktor S immer positiv ist, falls der Koeffizient $\mu$, wie in diesem Fall, zwischen 0 und 1 liegt.

Liegt der Koeffizient $\mu$ im Bereich zwischen -1 und 0, entsprechen dem Ausführungsbeispiel nach FIG 2, so muß auch der Adaptor des Übertragungsfilters aus Skalierungsgründen modifiziert werden. Demzufolge ändert sich auch der Adaptor des Gradientenfilters. Für den Skalierungsfaktor S gilt dann:

$$S = 1 + \mu \qquad (5)$$

für das Signal $b_2'$ folgt dann:

$$b_2' = (1 + \mu) \cdot a_1' + \mu \cdot a_2' \qquad (6a)$$

$$|b_2'| \leq |1 + \mu| \cdot |a_1'| + |\mu| \cdot |a_2'| \qquad (6b)$$

$$|b_2'| \leq |1 + \mu| + |\mu| \qquad (6c)$$

$$|b_2'| \leq 1 \qquad (6d)$$

Damit ist gewährleistet, daß auch der Adaptor AG2 wie auch der Adaptor AG1 für das Ausgangssignal $b_2'$ unter keinen Umständen Überläufe erzeugen kann.

Abschließend sei darauf hingewiesen, daß das Übertragungsfilter auch aus mehreren Übertragungsteilfiltern mit jeweils einem Adaptor mit positivem oder negativem Koeffizienten bestehen kann. Jedem Teilübertragungsfilter, nach dessen Koeffizienten das Ausgangssignal abgeleitet werden soll, wird dann jeweils ein Gradientenfilter zugeordnet, das über eine Zwischenschaltung eines Multiplizierers zur Multiplikation mit einem von dem jeweiligen Koeffizienten abhängigen Skalierungsfaktor mit dem entsprechenden Übertragungsteilfilter verbunden ist.

**Patentansprüche**

1. Verfahren zur Vermeidung von Überläufen bei einem aus einem Übertragungsfilter (ÜF) und einem Gradientenfilter (GF1,GF2) bestehenden adaptiven rekursiven Wellendigitalfilter, wobei Übertragungsfilter (ÜF1,ÜF2) und Gradientenfilter (GF1,GF2) jeweils einen Adaptor (AÜ1,AÜ2) mit gegebenem Koeffizienten ($\mu$) aufweisen, **dadurch gekennzeichnet,** daß das von dem Übertragungsfilter (ÜF1,ÜF2) an das Gradientenfilter (GF1,GF2) abgegebene Signal mit einem Skalierungsfaktor (S) multipliziert wird, der gleich der Differenz von 1 und dem Betrag des gegebenen Koeffizienten ($\mu$) ist.

2. Schaltungsanordnung zur Durchführung des Verfahrens nach Anspruch 1, **gekennzeichnet durch** ein positives Vorzeichen des gegebenen Koeffizienten ($\mu$), durch einen Adaptor (AÜ1) des Übertragungsfilters (ÜF1), bei dem die einspeisenden Anschlüsse mit einem ersten Addierer (A1) verbunden sind unter Einfügung eines Vorzeicheninverters (V1) in eine dieser Zuleitungen, bei dem mit jeweils einem der beiden einspeisenden Anschlüsse ein zweiter bzw. dritter Addierer (A2,A3) verbunden ist, denen als zusätzliche Einspeisung der Ausgang des ersten Addierers (A1) unter Zwischenschaltung eines ersten Multiplizierers (M1) zur Multiplikation mit dem gegebenen Koeffizienten ($\mu$) zugeführt ist und bei dem die Ausgangsanschlüsse des zweiten und dritten Addierers (A2, A3) die Ausgangsklemmen bilden, durch einen Adaptor (AG1) des Gradientenfilters (GF1), bei dem die einspeisenden Anschlüsse mit einem vierten Addierer (A4) verbunden sind, unter Einfügung eines zweiten Multiplizierers (M2) zur Multiplikation mit dem gegebenen Koeffizienten ($\mu$) in einer dieser Zuleitungen, bei dem der Eingangsanschluß des zweiten Multiplizierers (M2) und der Ausgangsanschluß des vierten Addierers (A4) mit einem fünften Addierer (A5) verbunden sind und bei dem die Ausgangsanschlüsse des vierten und fünften Addierers (A4, A5) die Ausgangsklemmen bilden, und durch einen dritten Multiplizierer (M3) zur Multiplikation mit dem Skalierungsfaktor (S), dessen Eingangsanschluß mit dem Eingangsanschluß des ersten Multiplizierers (M1) und dessen Ausgangsanschluß mit dem direkt auf den vierten Addierer (A4) geführten einspeisenden Anschluß des Gradientenfilters (GF1) verbunden ist.

3. Schaltungsanordnung zur Durchführung des Verfahrens nach Anspruch 1, **gekennzeichnet durch** ein negatives Vorzeichen des gegebenen Koeffizienten ($\mu$), durch ein Adaptor (AÜ2) des Übertragungsfilters (ÜF2), bei dem die einspeisenden Anschlüsse mit einem ersten Addierer (A1) verbunden sind, bei dem mit jeweils einem der einspeisenden Anschlüsse ein zweiter und dritter Addierer (A2, A3) verbunden ist, denen als zusätzliche Einspeisung der Ausgang des ersten Addierers (A1) unter Zwischenschaltung eines ersten Multiplizierers (M1) zur Multiplikation mit dem gegebenen Koeffizienten ($\mu$) und unter Einfügung eines Vorzeicheninverters (V1) in eine dieser Zuleitungen zugeführt ist und bei dem die Ausgangsanschlüsse des zweiten und dritten Addierers (A2, A3) die Ausgangsklemmen bilden, durch einen Adaptor (AG2) des Gradientenfilters (GF2), bei dem die einspeisenden Anschlüsse mit einem vierten Addierer (A4) verbunden sind, unter Einfügung eines zweiten Multiplizierers (M2) zur Multiplikation mit dem gegebenen Koeffizienten ($\mu$) in eine dieser Zuleitungen, bei dem der Eingangsanschluß des zweiten Multiplizierers (M2) und unter Zwischenschaltung eines weiteren Vorzeicheninverters (V2) der Ausgangsanschluß des vierten Addierers (A4) mit einem fünften Addierer (A5) verbunden sind und bei dem die Ausgangsanschlüsse des vierten und fünften Addierers (A4, A5) die Ausgangsklemmen bilden, und durch einen dritten Multiplizierer (M3) zur Multiplikation mit dem Skalierungsfaktor (S), dessen Eingangsanschluß mit dem Eingangsanschluß des ersten Multiplizierers (M1) des Übertragungsfilters (ÜF2) und dessen Ausgangsanschluß mit dem direkt auf den vierten Addierer (A4) geführten einspeisenden Anschluß des Gradientenfilters (GF2) verbunden ist.

4. Schaltungsansordnung nach Anspruch 2 und/oder 3,
   **dadurch gekennzeichnet**,
   daß das Übertragungsfilter (ÜF1, ÜF2) aus mehreren Übertragungsteilfiltern mit jeweils einem Adaptor mit positiven oder negativen Koeffizienten besteht und
   daß jedem Übertragungsteilfilter ein Gradientenfilter zugeordnet ist, das über eine Zwischenschaltung eines Multiplizierers zur Multiplikation mit einem von dem jeweiligen Koeffizienten abhängigen Skalierungsfaktor mit dem entsprechenden Übertragungsteilfilter verbunden ist.

**Claims**

1. Method for avoiding overflow in an adaptive, recursive digital wave filter comprising a transmission filter (ÜF) and a gradient filter (GF1, GF2), the transmission filter (ÜF1, ÜF2) and gradient filter (GF1, GF2), in each case having an adaptor (AÜ1, AÜ2) with given coefficient ($\mu$), characterized in that the signal transmitted from the transmission filter (ÜF1, ÜF2) to the gradient filter (GF1, GF2) is multiplied by a scaling factor (S) which is equal to the difference between 1 and the amount of the given coefficient ($\mu$).

2. Circuit arrangement for carrying out the method according to Claim 1, characterized by a positive sign of the given coefficient ($\mu$), by an adaptor (AÜ1) of the transmission filter (ÜF1), in the case of which the input terminals are connected to a first adder (A1) accompanied by the insertion of a sign inverter (V1) into one of these supply leads, in the case of which a second and third adder (A2, A3) are respectively connected to one of the two input terminals, to which adders the output of the first adder (A1) is fed, accompanied by the insertion of a first multiplier (M1), as additional input for the purpose of multiplication by the given coefficient ($\mu$), and in the case of which the output terminals of the second and third adder (A2, A3) form the output terminals, by an adaptor (AG1) of the gradient filter (GF1), in the case of which the input terminals are connected to a fourth adder (A4), accompanied by the insertion of a second multiplier (M2), for the purpose of multiplication by the given coefficient ($\mu$) in one of these supply leads, in the case of which the input terminal of the second multiplier (M2) and the output terminal of the fourth adder (A4) are connected to a fifth adder (A5), and in the case of which the output terminals of the fourth and fifth adder (A4, A5) form the output terminals, and by a third multiplier (M3) for the purpose of multiplication by the scaling factor (S), whose input terminal is connected to the input terminal of the first multiplier (M1) and whose output terminal is connected to the input terminal of the gradient filter (GF1) which is led directly to the fourth adder (A4).

3. Circuit arrangement for carrying out the method according to Claim 1, characterized by a negative sign of the given coefficient ($\mu$), by an adaptor (AÜ2) of the transmission filter (ÜF2), in the case of which the input terminals are connected to a first adder (A1), in the case of which a second and third adder (A2, A3) are respectively connected to one of the input terminals, to which adders the output of the first adder (A1) is fed, accompanied by the insertion of a first multiplier (M1), as additional input for the purpose of multiplication by the given coefficient ($\mu$), and accompanied by the insertion of a sign inverter (V1) into one of these supply leads and in the case of which the output terminals of the second and third adder (A2, A3) form the output terminals, by an adaptor (AG2) of the gradient filter (GF2), in the case of which the input terminals are connected to a fourth adder (A4), accompanied by the insertion of a second multiplier (M2), for the purpose of multiplication by the given coefficient ($\mu$) in one of these supply leads, in the case of which the input terminal of the second multiplier (M2) and the output terminal of the fourth adder (A4) are connected and accompanied by the insertion of a further sign inverter (V2) to a fifth adder (A5), and in the case of which the output terminals of the fourth and fifth adder (A4, A5) form the output terminals, and by a third multiplier (M3) for the purpose of multiplication by the scaling factor (S), whose input terminal is connected to the input terminal of the first multiplier (M1) of the transmission filter (ÜF2) and whose output terminal is connected to the input terminal of the gradient filter (GF2) which is led directly to the fourth adder (A4).

4. Circuit arrangement according to Claims 2 and/or 3, characterized in that the transmission filter (ÜF1, ÜF2) comprises a plurality of transmission subfilters each having an adaptor with a positive or negative coefficient, and in that each transmission filter is assigned a gradient filter which is connected via an insertion of a multiplier for the purpose of multiplication by a scaling factor dependent on the respective coefficient to the corresponding transmission subfilter.

**Revendications**

1. Procédé pour éviter des dépassements de capacité dans un filtre d'ondes numérique, adaptatif et récursif, constitué d'un filtre de transfert (ÜF) et d'un filtre à gradient (GF1, GF2), des filtres de transfert (ÜF1, ÜF2) et des filtres à gradient (GF1, GF2) comportant chacun un adaptateur (AÜ1, AÜ2) à coefficient ($\mu$) donné, caractérisé par le fait que le signal, fourni par le filtre de transfert (ÜF1, ÜF2) au filtre à gradient (GF1, GF2), est multiplié par un facteur d'échelle (S), qui est égal à la différence entre 1 et la valeur absolue du coefficient donné ($\mu$).

2. Montage pour la mise en oeuvre du procédé suivant la revendication 1, caractérisé par un signe positif du coefficient ($\mu$) donné, par un adaptateur (AÜ1) du filtre de transfert (ÜF1), dans lequel les bornes d'alimentation sont reliées à un premier additionneur (A1), moyennant l'insertion d'un inverseur de signe (V1) dans l'une de ces lignes d'alimentation, et dans lequel aux deux bornes respectives d'alimentation sont reliés des second et troisième additionneurs (A2, A3), auxquels est reliée, en tant qu'unité d'alimentation supplémentaire, la sortie du premier additionneur (A1), par le montage intermédiaire d'un premier multiplicateur (M1) effectuant la multiplication par un coefficient ($\mu$) donné, et dans lequel les bornes de sortie des deuxième et troisième additionneurs (A2, A3) forment les bornes de sortie, par un adaptateur (AG1) du filtre à gradient (GF1), dans lequel les bornes d'alimentation sont reliées à un quatrième additionneur (A4), par le montage intermédiaire d'un deuxième multiplicateur (M2) effecuant la multiplication par le coefficient ($\mu$) donné dans l'une de ses lignes d'alimentation, et dans lequel la borne d'entrée du deuxième multiplicateur (M2) et la borne de sortie du quatrième additionneur (A4) sont reliées à un cinquième additionneur (A5), et dans lequel les bornes de sortie des quatrième et cinquième additionneurs (A4, A5) forment les bornes de sortie, et par un troisième multiplicateur (M3) effectuant la multiplication par un facteur d'échelle (S), dont la borne d'entrée est reliée à la borne d'entrée du premier multiplicateur (M1) et dont la borne de sortie est reliée à la borne d'alimentation du filtre à gradient (GF1) reliée directement au quatrième additionneur (A4).

3. Montage pour la mise en oeuvre du procédé suivant la revendication 1, caractérisé par un signe négatif du coefficient ($\mu$) donné, par un adaptateur (AÜ2) du filtre de transfert (ÜF2), dans lequel les bornes d'alimentation sont reliées à un premier additionneur (A1), et dans lequel aux deux bornes respectives d'alimentation sont reliés des deuxième et troisième additionneurs (A2, A3), auxquels est reliée, en tant qu'unité d'alimentation supplémentaire, la sortie du premier additionneur (A1), par le montage intermédiaire d'un premier multiplicateur (M1) effectuant une multiplication par le coefficient ($\mu$) donné et par l'insertion d'un inverseur de signe (V1) dans l'une de ces lignes d'alimentation, et dans lequel les bornes de sortie des deuxième et troisième additionneurs (A2, A3) forment les bornes de sortie, par un adaptateur (AG2) du filtre à gradient (GF2), dans lequel les bornes d'alimentation sont reliées à un quatrième additionneur (A4), moyennant l'insertion d'un deuxième multiplicateur (M2) effectuant une multiplication avec le coefficient ($\mu$) donné dans l'une de ces lignes d'alimentation, et dans lequel la borne d'entrée du deuxième multiplicateur (M2) et, moyennant l'interposition d'un autre inverseur de signe (V2), la borne de sortie du quatrième additionneur (A4) sont reliées à un cinquième additionneur (A5), et dans lequel les bornes de sortie des quatrième et cinquième additionneurs (A4, A5) forment des bornes de sortie, et par un troisième multiplicateur (M3), qui effectue la multiplication par le facteur d'échelle (S), dont la borne d'entrée est reliée à la borne d'entrée du cinquième multiplicateur (M1) du filtre de transfert (ÜF2) et dont la borne de sortie est reliée à la borne d'alimentation du filtre à gradient (GF2) reliée directement au quatrième additionneur (A4).

4. Montage suivant la revendication 2 et/ou 3, caractérisé par le fait
que le filtre de transfert (ÜF1, ÜF2) est constitué de plusieurs filtres partiels de transfert comportant respectivement un adapteur à coefficient positif ou négatif, et
qu'à chaque filtre partiel de transfert est associé un filtre à gradient, qui est relié au filtre partiel de transfert correspondant, par le montage intermédiaire d'un multiplicateur effectuant la multiplication par un facteur d'échelle qui dépend du coefficient respectif.

# FIG 1

# FIG 2